## Europäisches Patentamt
## European Patent Office
## Office européen des brevets

(11) Veröffentlichungsnummer: **0 195 885 B1**

(12)

# EUROPÄISCHE PATENTSCHRIFT

(45) Veröffentlichungstag der Patentschrift: **16.10.91**

(21) Anmeldenummer: **86100373.9**

(22) Anmeldetag: **02.06.82**

(51) Int. Cl.⁵: **H03K 21/40**

(60) Veröffentlichungsnummer der früheren Anmeldung nach Art. 76 EPÜ: **0 067 364**

(54) Verfahren und Anordnung zum nichtflüchtigen Speichern des Zählerstandes einer elektronischen Zählschaltung.

(30) Priorität: **12.06.81 DE 3123444**

(43) Veröffentlichungstag der Anmeldung:
**01.10.86 Patentblatt 86/40**

(45) Bekanntmachung des Hinweises auf die Patenterteilung:
**16.10.91 Patentblatt 91/42**

(84) Benannte Vertragsstaaten:
**AT DE FR GB IT**

(56) Entgegenhaltungen:
**EP-A- 0 026 980**
**DE-A- 2 907 776**
**FR-A- 2 408 118**
**FR-A- 2 421 493**
**GB-A- 1 322 869**

**IEEE INTERNATIONAL SYMPOSIUM ON FAULT-TOLERANT COMPUTING, 21.-23. Juni 1976, Pittsburgh, PA, Seiten 138-147, IEEE, Long Beach, CA, US; F.J. O'BRIEN: "Rollback point insertion strategies"**

(73) Patentinhaber: **SIEMENS AKTIENGESELL-SCHAFT**
**Wittelsbacherplatz 2**
**W-8000 München 2(DE)**

(72) Erfinder: **Schrenk, Hartmut, Dr. Dipl.-Phys.**
**Fasanenweg 22**
**W-8013 Haar(DE)**

Rank Xerox (UK) Business Services

## Beschreibung

Die Erfindung betrifft ein Verfahren und eine Anordnung zum nichtflüchtigen Speichern des Zählerstandes einer elektronischen Zählschaltung, bei dem der jeweilige Zählerstand durch elektrisches Umprogrammieren eines nichtflüchtigen Datenspeichers abgespeichert wird.

Im Bereich der Zähltechnik werden insbesondere in der Kraftfahrzeugtechnik z.B. als Kilometerzähler in der Regel mechanische Zählwerke verwendet, bei denen das Festhalten bzw. Abspeichern des jeweiligen Zählerstandes unproblematisch ist. Mit der Entwicklung nichtflüchtiger, elektrisch umprogrammierbarer Speicher (EEPROM's) ist es möglich geworden, wie bei den bekannten Random Access Speichern (RAM's) die gespeicherte Information einerseits zu ändern, die geänderte Information andererseits aber, ähnlich wie in den bekannten Read Only Memories (ROM's), auch ohne Betriebsspannung zu speichern. EEPROM's vereinigen also die positiven Eigenschaften beider Speichertypen und können deshalb grundsätzlich überall da eingesetzt werden, wo die sich ändernden Daten auch nach Abschalten der Betriebsspannung gesichert werden müssen. Insbesondere eignen sie sich in diesem Zusammenhang zur Speicherung des Zählerstandes einer elektronischen Zählschaltung.

EEPROM-Speicher benötigen aber eine Umprogrammierzeit, die bei handelsüblichen EEPROM-Speichern zwischen 1 ms und 1 s liegt. Diese Eigenschaft steht bei unvorhergesehenem Abschalten der Betriebsspannung, z.B. in einem Störungsfall, der zuverlässigen Datensicherung entgegen, da während der Umprogrammierzeit die abgespeicherte Information undefiniert ist. Wird während des Umprogrammierens die Betriebsspannung z.B. in einem Störungsfall abgeschaltet, so kann im angewählten Speicherbereich sowohl die alte als auch die neue Information verloren sein.

Dieses Risiko kann dadurch verringert werden, daß man den EEPROM-Speicher gemeinsam mit den notwendigen Ansteuerschaltungen mit einem getrennten Stromkreis betreibt, der aus einer eigenen Batterie oder einem geeigneten Speicherkondensator gespeist wird, und die nichtflüchtige Speicherung von der extern zugeführten Spannung weitgehend unabhängig macht. Als Nachteile bleiben aber nicht nur ein erhöhtes Restrisiko für die Zuverlässigkeit der Datensicherung, insbesondere nach mehreren kurzzeitigen und dicht aufeinanderfolgenden Einbrüchen der Versorgungsspannung, sondern auch der Aufwand für den eigenen, die Beendigung eines Programmiervorgangs nach Abschalten der externen Betriebsspannung ermöglichenden Versorgungskreis.

Aus der EP-A 0 026 980 ist ein Verfahren bekannt, bei dem Teile eines nicht-flüchtigen Speichers, sogenannte "pages" in einen flüchtigen Speicher ausgelesen werden, dort verändert werden und anschließend wieder in den nicht-flüchtigen Speicher eingeschrieben werden. Dieses Verfahren unterscheidet sich jedoch in wesentlichen Punkten sowohl vom gattungsgemäßen Verfahren als auch vom erfindungsgemäßen Verfahren: Während das Verfahren nach EP-A 0 026 980 u.a. einen flüchtigen Speicher verwendet, werden sowohl das gattungsgemäße Verfahren als auch das erfindungsgemäße Verfahren auf den Zählerstand einer elektronischen Zählschaltung angewandt. Die Zählschaltung kann naturgemäß nur (numerische) Zählwerte als Zählerstand aufweisen, wohingegen der flüchtige Speicher der EP-A 0 026 980 beliebige Werte, insbesondere Datenverarbeitungsprogramme speichern kann. Unterschiede bestehen auch in der Veränderung des Inhalts des flüchtigen Speichers bzw. des Zählerstandes: Der Inhalt des flüchtigen Speichers kann mittels eines manuell zu bedienenden Ein-/Ausgabegerätes beliebig verändert werden; die Zählschaltung hingegen ändert ihren Zählerstand in Abhängigkeit von (automatisch erzeugten) Zählimpulsen in entsprechenden, den Zählimpulsen zugeordneten Zählschritten.

Nachteilig beim Verfahren nach EP-A 0 026 980 ist insbesondere, daß zu seiner Durchführung außer einer Ablaufsteuerung (CPU) noch mehrere weitere Steuereinheiten (bubble memory controller, direct memory access controller) benötigt werden. Außerdem werden dort zur ordnungsgemäßen Durchführung des Verfahrens mindestens drei verschiedene Speicherbereiche benötigt: Ein üblicher, vollwertiger, nichtflüchtiger Speicherbereich bzw. Teile davon ("page") sowie ein als "save area" und ein als "blank page" bezeichneter Speicherbereich. Die beiden letzteren dienen der Aufnahme von zu sichernden Daten beim Auslesen bzw. zum Zwischenspeichern von einzuschreibenden, veränderten Daten. Sie sind jedoch aufgrund ihrer Dimensionierung nicht geeignet, sämtliche mögliche auszulesende Daten bzw. einzuschreibende Daten (mehrere pages) aufzunehmen, sondern nur jeweils einen bestimmten Teil davon (eine "page") zum Zwischenspeichern. Entsprechende Unterschiede zwischen dem Verfahren nach der EP-A 0 026 980 und der vorliegenden Erfindung bestehen auch bezüglich der Datensicherung bzw. -wiedergewinnung nach einem Spannungsausfall oder einem unerlaubten Spannungsabfall. Während beim obengenannten Verfahren bei jedem Auslesen aus dem nichtflüchtigen Speicher der flüchtige Speicher nach einem "verbotenen Muster" durchsucht wird (Nachteil: Zeitverbrauch), wird bei der vorliegenden Erfindung nur nach einer (von einer Sensorschaltung erkannten) Unterbrechung eines Speichervorganges der nicht-flüchtige Speicher auf gelöschte Adreßbereiche überprüft.

Aufgabe der vorliegenden Erfindung ist es, hier Abhilfe zu schaffen und ein Verfahren bzw. eine Anordung zum nichtflüchtigen Speichern des Zählerstandes einer elektronischen Zählschaltung vorzusehen, das auch bei Betriebsspannungseinbrüchen eine sichere Speicherung des Zählerstandes ermöglicht, ohne daß ein zusätzlicher Stromkreis benötigt wird.

Die erfindungsgemäße Aufgabe wird bei einem Verfahren bzw einer Anordung der eingangs genannten Art durch die kennzeichnenden Merkmale der Ansprüche 1 und 4 gelöst.

Es ist ein wesentliches Merkmal der Erfindung, daß bei Unterbrechung des Umprogrammiervorganges bei Vorliegen zweier belegter Adreßbereiche der in der festliegenden Reihenfolge später auszulesende Zählerstand in die Zählschaltung übernommen wird und bei Vorliegen dreier belegter Adreßbereiche der um den Wert "1" erhöhte Zählerstand des bezüglich der festliegenden Reihenfolge mittleren Adreßbereiches in die Zählschaltung übernommen wird.

Da die Informationsänderung im Datenspeicher, in dem der jeweilige Zählerstand nichtflüchtig registriert ist, in der Weise vorgenommen wird, daß man zunächst den neuen Zählerstand abspeichert, bevor man die den alten Zählinformationen vorhergehenden Zählinformationen löscht, bleibt bei einer Betriebsspannungsunterbrechung während des Abspeicherns des neuen Zählerstandes zumindest die korrekte Zählerinformation des alten Zählerstandes erhalten.

Unsicherheiten, welche von mehreren im Datenspeicher aufgefundenen Informationen nach einem gestörten Speichervorgang gültig sind, werden vermieden, da das Einschreiben der neuen Information in einen Adreßbereich grundsätzlich in einer bestimmten Reihenfolge der Adreßbereiche erfolgt und die alte Information auch nach dem Einschreiben der neuen Information erhalten bleibt. Bei Unterbrechung des Umprogrammiervorgangs kann nach dem Wiedereinschalten der Betriebsspannung aus den Zuständen der einzelnen Adreßbereiche auf eindeutige Weise erkannt werden, welcher Adreßbereich des Datenspeichers eine gültige Information enthält bzw. wie eine gültige Information aus der noch nicht gelöschten vorhergehenden Information rekonstruiert werden kann und wie der unterbrochene Umprogrammiervorgang nachträglich beendet werden kann. Das Umprogrammieren des Datenspeichers kann somit ohne Informationsverlust in einem beliebigen Zustand abgebrochen werden.

Es liegt im Rahmen der Erfindung, daß Steuerinformationen zur Beendigung eines unterbrochenen Umprogrammiervorgangs durch logische oder arithmetische Verknüpfung der im Datenspeicher gespeicherten Daten gewonnen werden.

Um eine Erhöhung der Zählrate zu ermöglichen, ist es von Vorteil, daß der Umprogrammiervorgang nur bei jeder nten Änderung des Zählerstandes durchgeführt wird.

Eine Anordnung zur Durchführung dieses erfindungsgemäßen Verfahrens wird vorteilhafterweise so durchgeführt, daß eine Zählschaltung vorgesehen ist, die über eine Ablaufsteuerung mit einem elektrisch umprogrammierbaren, mindestens vier Adreßbereiche aufweisenden, nichtflüchtigen Datenspeicher verbunden ist und daß eine mit der Ablaufsteuerung und dem Datenspeicher verbundene Auswertelogik vorgesehen ist, die durch logische oder arithmetische Verknüpfung der im Datenspeicher gespeicherten Daten Steuerinformationen zur Beendigung eines unterbrochenen Umprogrammiervorgangs liefert.

Da bei jedem Einbruch der Versorgungsspannung grundsätzlich die Möglichkeit der Veränderung der gerade bearbeiteten Daten besteht, wird der Abbruch des Umprogrammierablaufs vorteilhafterweise über einen an die Ablaufsteuerung ein Abbruchsignal liefernden Spannungssensor veranlaßt. Der Spannungssensor kann auch beim Wiedereinschalten der Betriebsspannung das Startsignal für alle erforderlichen Operationen liefern.

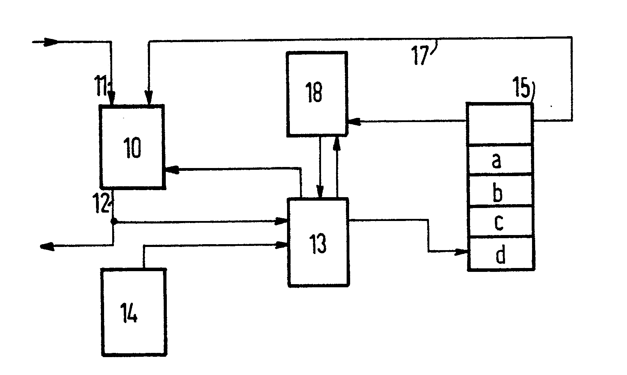

Die Erfindung wird im folgenden anhand der Figur näher erläutert. Die Figur zeigt das Blockschaltbild eines Ausführungsbeispiels zur Durchführung des erfindungsgemäßen Verfahrens.

Die in der Figur gezeigte Zählschaltung 10, z.B. ein handelsüblicher Zähler, übernimmt das Zählen der am Zähleingang 11 anliegenden einzelnen Ereignisse. Über ihren Ausgang 12 kann, gegebenenfalls unter Verwendung einer geeigneten Umkodierschaltung, der Zählerstand z.B. an einem Display angezeigt werden. Über die Ablaufsteuerung 13 wird der dem Ausgang 12 der Zählschaltung 11 entnehmbare Zählerstand dem Datenspeicher 15 zugeführt. Der zur Aufnahme der Zählerinformation dienende Datenspeicher 15 ist ein handelsüblicher, elektrisch programmier- und löschbarer Festwertspeicher (EEPROM), wie er beispielsweise aus W. Söll und J.-H. Kirchner, "Digitale Datenspeicher", 1978, Vogel-Verlag, Würzburg, Seiten 160 bis 163 bekannt ist, der mit Steuereingängen zur Kontrolle des Umprogrammierablaufs versehen ist. Alle erforderlichen Steuerinformationen werden allein im Datenspeicher 15 gespeichert, der von der Ablaufsteuerung 13 beaufschlagt ist und über die Auswertelogik 18 mit der Ablaufsteuerung 13 verbunden ist. Im Datenspeicher 15 werden die Zähldaten (Zählerstandsdaten) in diesem Falle mehrfach, d.h. mit erhöhter Redundanz abgespeichert.

Zur Aufnahme der Zähldaten sind im gezeigten Ausführungsbeispiel vier gleichwertige Adreßbereiche a, b, c, d im als EEPROM ausgeführten Datenspeicher 15 erforderlich, die immer in einer festliegenden

*Reihenfolge, z.B. zyklisch aufsteigend durchlaufen werden. Dies gilt sowohl für den Umprogrammiervorgang* bei Zählerstandsänderung als auch beim Auslesen des Speichers 15. Beim Umprogrammieren des Speichers 15 wird grundsätzlich die neue Zählerinformation (z.B. Zählerstand z + 1) in den nachfolgenden, d.h. entsprechend der festgelegten Reihenfolge nächsten, Adreßbereich übernommen, bevor die dem alten Zählerstand (z) vorhergehende Zählerinformation (Zählerstand z - 1) gelöscht wird. Es enthalten also grundsätzlich mindestens zwei Adreßbereiche eine Information.

Der Ablauf eines Umprogrammiervorganges vom Zählerstand z zum Zählerstand z + 5 mit den Dateninhalten der vier Adreßbereiche a, b, c, d, die zyklisch durchlaufen werden, und den einzelnen Umprogrammierschritten ist in der Tabelle verdeutlicht.

Beim Zählerstand z befindet sich die erfindungsgemäße Anordnung in Zählbereitschaft (Schritt 1, Standby). Im Adreßbereich a ist der alte Zählerstand z - 1, im Adreßbereich b der aktuelle (gültige) Zählerstand z gespeichert. Die Adreßbereiche c und d sind gelöscht. Bei einem nun auftretenden Zählimpuls (Zählerstand z + 1) wird zunächst der neue Zählerstand im Adreßbereich c übernommen (2. Schritt) und gespeichert (3. Schritt). Im 4. Schritt wird der alte Zählerstand im Adreßbereich a gelöscht, im 5. Schritt ist der Adreßbereich a gelöscht, der neue Zählerstand ist gültig übernommen. Die Übernahme der nächsten Zählerstände z + 2, z + 3, z + 4 und z + 5 in die in zyklisch aufsteigender Reihenfolge belegten Adreßbereiche a, b, c, d ist den folgenden Bereichen der Tabelle zu entnehmen.

Bei regulärer Beendigung des Speichervorgangs sind also zwei der vier Adreßbereiche a, b, c, d belegt. Der entsprechend der festgelegten Reihenfolge obere der beiden Adreßbereiche, der also beim z.B. zyklischen Auslesen später ausgelesen wird, enthält den gültigen, aktuellen Zählerstand, der vorhergehende Adreßbereich einen um 1 niedrigeren Datenwert. Nach Unterbrechung des Speichervorgangs, z.B. wegen eines Betriebsspannungseinbruchs, erkennt die Auswertelogik 18, daß 3 der Adreßbereiche a, b, c, d eine Information besitzen, die von 0 verschieden ist. In diesem Fall läßt sich die gültige Information, d.h. der gültige Zählerstand nach dem Wiederanschalten der Zählschaltung wie folgt ermitteln:
Der zweite belegte Adreßbereich nach dem nicht belegten Adreßbereich, d.h. der mittlere der drei belegten Adreßbereiche entsprechend der vorgegebenen Reihenfolge, enthält in jedem Fall eine zwar ungestörte, aber um einen Zählimpuls zu niedrige Zählinformation. Durch Übernahme dieses Wertes in die beispielsweise als Vorwahlzähler ausgeführte Zählschaltung 10 und Ergänzung des fehlenden Impulses über die Ablaufsteuerung 13 ist der korrekte Zählerstand zurückgewonnen. Über die Ablaufsteuerung 13 kann der Speichervorgang, d.h. das Beschreiben des dritten und Löschen des ersten Adreßbereiches nach dem unbelegten Adreßbereich wiederholt werden.

Auf diese Weise gelingt es ebenfalls bei Unterbrechung des Umprogrammiervorgangs nach dem Wiedereinschalten der erfindungsgemäßen Zählanordnung die gültige Information aus einer noch nicht gelöschten vorausgehenden Information zu gewinnen und die Umprogrammierung nachträglich zu beenden.

Eine die Ablaufsteuerung 13 beaufschlagende Sensorschaltung 14 erkennt einen Einbruch der Versorgungsspannung und liefert ein geeignetes Abbruchsignal an die Ablaufsteuerung 13. Die Sensorschaltung 14 kann auch so ausgeführt sein, daß sie bei Spannungsspitzen der Versorgungsschaltung ("Spikes") ein Abbruchsignal liefert. Beim Einschalten der erfindungsgemäßen Anordnung gibt die Sensorschaltung 14 ferner ein Startsignal für die Abfrage ab. Sie kann entsprechend der bei Mikrocomputern üblichen Reset-Schaltungen (wie z.B. in U. Tietze und Ch. Schenk, "Halbleiter-Schaltungstechnik", Springer-Verlag, Berlin, Heidelberg, New York, 1980, Seiten 558, 559 beschrieben) ausgeführt sein.

Bei Verwendung eines entsprechenden Mikroprozessors kann die gesamte erfindungsgemäße Anordnung mit einem Mikroprozessor und einem elektrisch umprogrammierbaren nichtflüchtigen Speicher realisiert werden. Es ist aber auch möglich, die erforderlichen Schaltungsteile in einem oder mehreren anwendungsspezifischen Schaltkreisen zu integrieren.

## Tabelle

| Zählerstand | Daten im →a →b →c →d | | | | Schritt, Vorgang | |
|---|---|---|---|---|---|---|
| Z | Z-1 | Z | 0 | 0 | 1. Standby | |
| Z+1 | Z-1 | Z | ≠0 | 0 | 2. Neuen Zählerstand speichern | Umprogrammieren |
| Z+1 | Z-1 | Z | Z+1 | 0 | 3. Neuer Zählerstand gespeichert | |
| Z+1 | ≠0 | Z | Z+1 | 0 | 4. Alten Zählerstand löschen | |
| Z+1 | 0 | Z | Z+1 | 0 | 5. Neuer Zählerstand gültig | |
| Z+2 | 0 | ≠0 | Z+1 | ≠0 | Umprogrammieren entsprechend oben, Schritte 2 - 4 | |
| Z+2 | 0 | 0 | Z+1 | Z+2 | Zählerstand Z+2 gültig | |
| Z+3 | ≠0 | 0 | ≠0 | Z+2 | Umprogrammieren | |
| Z+3 | Z+3 | 0 | 0 | Z+2 | Zählerstand Z+3 gültig | |
| Z+4 | Z+3 | ≠0 | 0 | ≠0 | Umprogrammieren | |
| Z+4 | Z+3 | Z+4 | 0 | 0 | Zählerstand Z+4 gültig | |
| Z+5 | ≠0 | Z+4 | ≠0 | 0 | Umprogrammieren | |
| Z+5 | 0 | Z+4 | Z+5 | 0 | Zählerstand Z+5 gültig | |

u. s. w.

## Patentansprüche

1. Verfahren zum nichtflüchtigen Speichern des Zählerstandes einer elektronischen Zählschaltung, bei dem der jeweilige Zählerstand durch elektrisches Umprogrammieren eines nichtflüchtigen Datenspeichers (15) abgespeichert wird,
   **dadurch gekennzeichnet,**
   - daß zum Umprogrammieren und Auslesen des Zählerstandes mindestens vier Adreßbereiche (a, b, c, d) des Datenspeichers (15) in einer festliegenden Reihenfolge durchlaufen werden, wobei jeweils zwei der vier aufeinanderfolgenden Adreßbereiche die Zählerstandsdaten des vorletzten und des letzten Zählereignisses enthalten,
   - daß beim Umprogrammieren des Datenspeichers (15) die Zählerstandsdaten eines neuen Zählereignisses in den auf den Adreßbereich (b) für den Zählerstand des letzten Zählereignisses folgenden Adreßbereich (c) übernommen werden,

EP 0 195 885 B1

- daß anschließend der Adreßbereich (a), in dem der Zählerstand des vorletzten Zählereignisses gespeichert ist, gelöscht wird, und
- daß bei Unterbrechung des Umprogrammiervorgangs bei Vorliegen zweier belegter Adreßbereiche der in der festliegenden Reihenfolgen später auszulesende Zählerstand in die Zählschaltung (10) übernommen wird und bei Vorliegen dreier belegter Adreßbereiche der um den Wert "1" erhöhte Zählerstand des bezüglich der festliegenden Reihenfolge mittleren Adreßbereiches in die Zählschaltung (10) übernommen wird.

2. Verfahren nach Anspruch 1,
**dadurch gekennzeichnet,**
daß Steuerinformationen zur Beendigung eines unterbrochenen Umprogrammiervorgangs durch logische oder arithmetische Verknüpfung der im Datenspeicher (15) gespeicherten Daten gewonnen werden.

3. Verfahren nach einem der Ansprüche 1 oder 2,
**dadurch gekennzeichnet,**
daß der Umprogrammiervorgang nur bei jeder n-ten Änderung des Zählerstandes durchgeführt wird.

4. Anordnung mit einem nichtflüchtigen elektrisch umprogrammierbaren Datenspeicher (15) mit mindestens vier Adressbereichen (a, b, c, d) und einer Ablaufsteuerung (13) zur Durchführung des Verfahrens nach einem der Ansprüche 1 bis 3,
**dadurch gekennzeichnet, daß**
- eine Zählschaltung (10) vorgesehen ist, die über die Ablaufsteuerung (13) mit dem nichtflüchtigen elektrisch umprogrammierbaren, mindestens vier Adreßbereiche (a, b, c, d) aufweisenden, nichtflüchtigen Datenspeicher (15) verbunden ist,
- eine Zählschaltung (10) vorgesehen ist, die über die Ablaufsteuerung (13) mit dem nichtflüchtigen elektrisch umprogrammierbaren, mindestens vier Adressbereiche (a, b, c, d) aufweisenden, nichtflüchtigen Datenspeicher (15) verbunden ist,
- daß eine mit der Ablaufsteuerung (13) und dem Datenspeicher (15) verbundene Auswertelogik (18) vorgesehen ist,
- daß die Auswertelogik zum Umprogrammieren und Auslesen des Zählerstandes mindestens vier Adreßbereiche (a, b, c, d) des Datenspeichers (15) in einer festliegenden Reihenfolgen durchläuft, und so den zu programmierenden bzw. auszulesenden Adreßbereich ermittelt,
- daß die Ablaufsteuerung (13) beim Umprogrammieren des Datenspeiches (15) die Zählerstandsdaten eines neuen Zählereignisses in den auf den Adreßbereich (b) für den Zählerstand des letzten Zählereignisses folgenden durch die Auswertelogik ermittelten Adreßbereich (c) abspeichert,
- daß anschließend der Adreßbereich (a), in dem der Zählerstand des vorletzten Zählereignisses gespeichert ist, durch die Ablaufsteuerung (13) gelöscht wird, und
- daß die Auswertelogik (18) und Ablaufsteuerung (13) bei Unterbrechung des Umprogrammiervorgangs bei Vorliegen zweier belegter Adreßbereiche den in der festliegenden Reihenfolge später auszulesenden Zählerstand in die Zählschaltung (10) übergeben und bei Vorliegen dreier belegter Adreßbereiche den um den Wert "1" erhöhten Zählerstand des bezüglich der festliegenden Reihenfolge mittleren Adreßbereiches in die Zählschaltung (10) übergeben.

5. Anordnung nach Anspruch 4,
**dadurch gekennzeichnet,**
daß eine im Falle eines Einbruchs der Versorgungsspannung ein Abbruchsignal an die Ablaufsteuerung (13) liefernde Sensorschaltung (14) vorgesehen ist.

## Claims

1. Method for the non-volatile storage of the count of an electronic counting circuit, in which the respective count is stored by electrically reprogramming a nonvolatile data memory (15), characterised in that, for reprogramming and reading out the count, at least four address areas (a, b, c, d) of the data memory are cycled through in a fixed order, in each case two of the four successive address areas containing the count data of the penultimate and of the last counting event,
in that, during reprogramming of the data memory (15), the count data of a new counting event are

6

transferred into the address area (c) following the address area (b) for the count of the last counting event, in that subsequently the address area (a) in which the count of the penultimate counting event is stored is erased, and

in that, when the reprogramming operation is interrupted when two occupied address areas are present, the count which is to be read out later in the fixed order is transferred into the counting circuit (10) and, when three occupied address areas are present, the count incremented by the value "1" of the middle address area with respect to the fixed order is transferred into the counting circuit (10).

2. Method according to Claim 1, characterised in that control information for terminating an interrupted reprogramming operation is obtained by logical or arithmetic gating of the data stored in the data memory (15).

3. Method according to one of Claims 1 or 2, characterised in that the reprogramming operation is carried out only at every $n^{th}$ alteration of the count.

4. Arrangement having a non-volatile, electrically reprogrammable data memory (15) with at least four address areas (a, b, c, d) and an execution controller (13) for carrying out the method according to one of Claims 1 to 3, characterised

in that a counting circuit (10) is provided which is connected via the execution controller (13) to the non-volatile, electrically reprogrammable, non-volatile [sic] data memory (15) having at least four address areas (a, b, c, d),

in that a counting circuit (10) is provided which is connected via the execution controller (13) to the non-volatile, electrically reprogrammable, non-volatile [sic] data memory (15) having at least four address areas (a, b, c, d) [sic],

in that an evaluation logic means (18) connected to the execution controller (13) and to the data memory (15) is provided,

in that, for reprogramming and reading out the count, the evaluation logic means cycles through at least four address areas (a,b,c,d) of the data memory (15) in a fixed order, and in this way determines the address area to be programmed or read out,

in that, during reprogramming of the data memory (15), the execution controller (13) stores the count data of a new counting event in the address area (c) following the address area (b) for the count of the last counting event and determined by the evaluation logic means,

in that subsequently the address area (a) in which the count of the penultimate counting event is stored is erased by the execution controller (13), and

in that the evaluation logic means (18) and execution controller (13), when the reprogramming operation is interrupted when two occupied address areas are present, transfer the count to be read out later in the fixed order into the counting circuit (10) and, when three occupied address areas are present, transfer the count incremented by the value "1" of the middle address area with respect to the fixed order into the counting circuit (10).

5. Arrangement according to Claim 4, characterised in that a sensor circuit (14) which supplies a cancel signal to the execution controller (13) in the event of a dip in the supply voltage is provided.

**Revendications**

1. Procédé pour réaliser la mémorisation non volatile de l'état de comptage d'un circuit de comptage électronique, selon lequel l'état respectif de comptage est mémorisé au moyen de la programmation électrique d'une mémoire non volatile de données (15), caractérisé par le fait

- que pour la programmation et la lecture de l'état de comptage, au moins quatre zones d'adresses (a,b,c,d) de la mémoire de données (15) sont parcourues selon une séquence fixe, respectivement deux des quatre zones successives d'adresses contenant l'état de comptage pour l'avant-dernier évènement et le dernier évènement de comptage,

- que lors de la programmation de la mémoire de données (15), les données de l'état de comptage pour un nouvel évènement de comptage sont transférées dans la zone d'adresses (c) qui succède à la zone d'adresses (b) pour l'état de comptage pour le dernier évènement de comptage,

- qu'ensuite la zone d'adresses (a), dans laquelle l'état de comptage pour l'avant-dernier évènement de comptage est mémorisé, est effacée, et

- que, lors de l'interruption du processus de programmation et lors de la présence de deux zones d'adresses occupées, l'état de comptage, qui doit être lu ultérieurement dans les séquences fixes, est transféré dans le circuit de comptage (10) et que, dans le cas de la présence de trois zones d'adresses occupées, l'état de comptage, accru de la valeur "1", de la zone d'adresses, qui est en position médiane dans la séquence fixe, est transféré dans le circuit de comptage (10).

2. Procédé suivant la revendication 1 caractérisé par le fait que des informations de commande servant à arrêter un processus interrompu de programmation, sont obtenues au moyen d'une combinaison logique ou arithmétique des données mémorisées dans la mémoire de données (15).

3. Procédé suivant l'une des revendications 1 ou 2, caractérisé par le fait que le processus de programmation n'est exécuté que lors de chaque n-ème modification de l'état de comptage.

4. Dispositif comportant une mémoire de données (15) non volatile et programmable électriquement, comportant au moins quatre zones d'adresses (a,b,c,d) et une unité de commande d'exécution (13) pour la mise en oeuvre du procédé suivant l'une des revendications 1 à 3, caractérisé par le fait
   - qu'il est prévu un circuit de comptage (10), qui est raccordé par l'intermédiaire de l'unité de commande d'exécution (13), à la mémoire non volatile de données (15), programmable électriquement, qui comporte au moins quatre zones d'adresses (a,b,c,d),
   - qu'il est prévu une unité logique d'évaluation (18) raccordée à l'unité de commande d'exécution (13) et à la mémoire de données (15),
   - que l'unité logique d'évaluation explore au moins quatre zones d'adresses (a,b,c,d) de la mémoire de données (15) selon une séquence fixe, pour réaliser la programmation et la lecture de l'état de comptage, et déterminer ainsi la zone d'adresses devant être programmée ou lue,
   - que, lors de la programmation de la mémoire de données (15), l'unité de commande d'exécution (13) mémorise les données d'état de comptage pour un nouvel évènement de comptage dans la zone d'adresses (c), qui succède à la zone d'adresses (b) concernant l'état de comptage pour le dernier évènement de comptage et est déterminée par l'unité logique d'évaluation,
   - qu'ensuite, la zone d'adresses (a), dans laquelle l'état de comptage pour l'avant-dernier évènement de comptage est mémorisé, est effacée par l'unité de commande d'exécution (13), et
   - que, dans le cas d'une interruption du processus de programmation, l'unité logique d'évaluation (18) et l'unité de commande d'exécution (13) transfèrent l'état de comptage, qui doit être lu ensuite selon la séquence fixe, dans le circuit de comptage (10), lors de la présence de deux zones d'adresses occupées, et transfèrent l'état de comptage, accru de la valeur "1", de la zone d'adresses, qui est en position médiane par rapport à la séquence fixe, dans le circuit de comptage (10) lors de la présence de trois zones d'adresses occupées.

5. Dispositif suivant la revendication 4, caractérisé par le fait qu'il est prévu un circuit de détection (14) qui, dans le cas d'une interruption de la tension d'alimentation, envoie un signal d'interruption à l'unité de commande d'exécution (13).

EP 0 195 885 B1